(19) Europäisches Patentamt
European Patent Office
Office européen des brevets

(11) EP 4 656 377 A1

(12) **EUROPEAN PATENT APPLICATION**
published in accordance with Art. 153(4) EPC

(43) Date of publication:
**03.12.2025 Bulletin 2025/49**

(21) Application number: **24747242.6**

(22) Date of filing: **22.01.2024**

(51) International Patent Classification (IPC):
***B32B 9/00*** *(2006.01)* ***H01L 21/312*** *(2006.01)*
***H01L 21/316*** *(2006.01)* ***H01L 21/318*** *(2006.01)*

(52) Cooperative Patent Classification (CPC):
**B32B 9/00**

(86) International application number:
**PCT/JP2024/001591**

(87) International publication number:
**WO 2024/157914 (02.08.2024 Gazette 2024/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **23.01.2023 JP 2023008163**

(71) Applicant: **Sekisui Chemical Co., Ltd.**
**Osaka-shi, Osaka 530-8565 (JP)**

(72) Inventors:
- **SHIOJIMA, Taro**
  **Mishima-gun, Osaka 618-0021 (JP)**
- **KUNISAWA, Tsukasa**
  **Mishima-gun, Osaka 618-0021 (JP)**
- **NOMOTO, Hayate**
  **Mishima-gun, Osaka 618-0021 (JP)**
- **SATO, Kenichiro**
  **Mishima-gun, Osaka 618-0021 (JP)**
- **DEGUCHI, Hidenobu**
  **Mishima-gun, Osaka 618-0021 (JP)**
- **SHICHIRI, Tokushige**
  **Mishima-gun, Osaka 618-0021 (JP)**
- **ASANO, Motohiko**
  **Mishima-gun, Osaka 618-0021 (JP)**

(74) Representative: **Cabinet Beau de Loménie**
**103, rue de Grenelle / CS 90800**
**75340 Paris Cedex 07 (FR)**

# (54) LAMINATED BODY, METHOD FOR MANUFACTURING LAMINATED BODY, METHOD FOR MANUFACTURING ELEMENT, IMAGING DEVICE, METHOD FOR MANUFACTURING IMAGING DEVICE, SEMICONDUCTOR DEVICE, AND METHOD FOR MANUFACTURING SEMICONDUCTOR DEVICE

(57) The present invention aims to provide a stack that, when a plurality of the stacks are stacked, can provide a semiconductor device in which elements are less likely to warp or crack, that has high moisture resistance, and that can impart excellent connection reliability, a method for producing the stack, a method for producing an element using the stack, an imaging device including the stack, a method for producing the imaging device, a semiconductor device including the stack, and a method for producing the semiconductor device. Provided is a stack including: a first element; an organic layer on the first element; and an inorganic layer on the organic layer, the organic layer having a 1% thermal weight loss temperature of 400°C or higher as measured at a temperature increase rate of 10°C/min under a nitrogen atmosphere, the inorganic layer having a thickness of 1 nm or greater and 1 μm or less, the inorganic layer including a $Si_3N_4$ layer, the inorganic layer having a compressive internal stress.



Processed by Luminess, 75001 PARIS (FR)

## Description

### TECHNICAL FIELD

The present invention relates to a stack, a method for producing a stack, a method for producing an element, an imaging device, a method for producing an imaging device, a semiconductor device, and a method for producing a semiconductor device.

### BACKGROUND ART

With higher performance of semiconductor devices, 3D stacking of multiple semiconductor chips has been developed. The production of such a semiconductor device including a stack of multiple semiconductor chips first includes the formation of a bonding surface, which includes copper-made bonding electrodes surrounded by an insulating film, by the damascene process on each of the electrode surfaces of two elements or circuit substrates (hereinafter simply "elements") provided with the electrodes. The two elements are then stacked on top of each other such that the bonding electrodes of the bonding surfaces face each other, and then heat-treated to produce a semiconductor device (Patent Literature 1).

### CITATION LIST

- Patent Literature

Patent Literature 1: JP 2006-191081 A

### SUMMARY OF INVENTION

- Technical problem

In the production of the semiconductor device, bonding of the electrodes involves high-temperature treatment at 400°C for four hours. The insulating layers used to form the bonding surfaces thus require high heat resistance. Conventional semiconductor devices therefore use insulating inorganic materials such as $Si_3N_4$ and $SiO_2$ as the insulating layers. However, insulating layers made of inorganic materials tend to cause warping of the substrates. A warped substrate may cause misalignment of the electrode connection positions or cracking of electrodes in stacking. This may reduce the connection reliability of the semiconductor device. As the recent semiconductor devices have higher performance, substrates have become larger and thinner, and thus become more susceptible to warping. Thin substrates, in particular, may crack.

To suppress warping and cracking of substrates due to high-temperature treatment, the insulating layers may be organic layers made of organic compounds, which are more flexible than inorganic materials. However, insulating layers made of organic compounds are vulnerable to heat and may easily crack due to outgassing caused by thermal decomposition. To counter this, insulating layers made of heat-resistant resins have been considered. However, resins, easily permeable to moisture, are vulnerable to high-humidity conditions. Moisture entering the electrodes under high-humidity conditions may reduce the reliability of the semiconductor device.

A proposed way to solve such moisture resistance problems is to stack a thin inorganic layer made of an inorganic material on an organic layer. Since inorganic materials have high moisture resistance, covering an organic layer with an inorganic layer can enhance the moisture resistance. A thin inorganic layer will not hinder the organic layer from exhibiting the effect of suppressing warping and cracking of substrates caused by high-temperature treatment.

Unfortunately, such an inorganic layer formed on an organic layer may crack in high-temperature treatment, reducing the reliability of the semiconductor device.

The present invention aims to provide a stack that, when a plurality of the stacks are stacked, can provide a semiconductor device in which elements are less likely to warp or crack, that has high moisture resistance, and that can impart excellent connection reliability, a method for producing the stack, a method for producing an element using the stack, an imaging device including the stack, a method for producing the imaging device, a semiconductor device including the stack, and a method for producing the semiconductor device.

- Solution to problem

The present invention encompasses the following disclosures 1 to 19. The present invention is described in detail below.

[Disclosure 1]

A stack including: a first element; an organic layer on the first element; and an inorganic layer on the organic layer,

the organic layer having a 1% thermal weight loss temperature of 400°C or higher as measured at a temperature increase rate of 10°C/min under a nitrogen atmosphere,
the inorganic layer having a thickness of 1 nm or greater and 1 μm or less,
the inorganic layer including a $Si_3N_4$ layer,
the inorganic layer having a compressive internal stress.

[Disclosure 2]

The stack according to the disclosure 1, wherein the inorganic layer includes a $SiO_2$ layer, and the $Si_3N_4$ layer is on the $SiO_2$ layer.

[Disclosure 3]

The stack according to the disclosure 1 or 2, wherein the organic layer is a cured product of a curable resin composition.

[Disclosure 4]

The stack according to the disclosure 3, wherein the organic layer is a cured product of a curable resin composition containing an organosilicon compound.

[Disclosure 5]

The stack according to the disclosure 4, wherein the organosilicon compound has a structure represented by the following formula (1):

[Chem. 1]

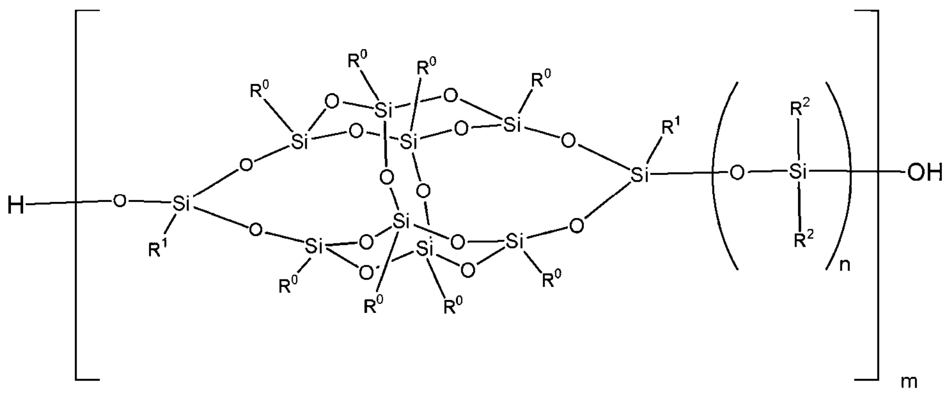

(1)

wherein $R^0$s, $R^1$s, and $R^2$s each independently represent a linear, branched, or cyclic aliphatic group, an aromatic group, or hydrogen; the aliphatic group and the aromatic group optionally have a substituent; and m and n each represent an integer of 1 or greater.

[Disclosure 6]

The stack according to the disclosure 5, wherein the stack satisfies P2180/P775 < 0.045, where P775 is a peak height at 775 $cm^{-1}$ (Si-O) and P2180 is a peak height at 2,180 $cm^{-1}$ (Si-H) in an IR spectrum measured from a surface of the inorganic layer by FT-IR.

[Disclosure 7]

The stack according to the disclosure 5 or 6, wherein the stack satisfies P1200/P775 < 0.300, where P775 is a peak height at 775 $cm^{-1}$ (Si-O) and P1200 is a peak height at 1,200 $cm^{-1}$ (N-H) in an IR spectrum measured from a surface of the inorganic layer by FT-IR.

[Disclosure 8]

The stack according to any one of the disclosures 1 to 7, wherein the organic layer has a thickness of 10 μm or greater.

[Disclosure 9]

The stack according to any one of the disclosures 1 to 8, wherein the first element has a first surface and a second surface, the first surface includes a plurality of chips, and the organic layer and the inorganic layer are on the first surface side.

[Disclosure 10]

The stack according to any one of the disclosures 1 to 9, further comprising a supporting substrate on the inorganic layer.

[Disclosure 11]

An imaging device including the stack according to any one of the disclosures 1 to 10.

[Disclosure 12]

A semiconductor device including the stack according to any one of the disclosures 1 to 10.

[Disclosure 13]

A method for producing the stack according to any one of the disclosures 1 to 10, comprising the steps of: forming the organic layer by forming a film of a curable resin composition on the first element; and forming the inorganic layer having a compressive internal stress on the organic layer by chemical vapor deposition.

[Disclosure 14]

The method for producing the stack according to the disclosure 13, wherein the first element has a first surface and a second surface, the first surface includes a plurality of chips, and the organic layer is formed on the first surface side in the organic layer forming step.

[Disclosure 15]

The method for producing the stack according to the disclosure 13 or 14, further comprising the step of bonding a supporting substrate onto the inorganic layer.

[Disclosure 16]

A method for producing an imaging device, comprising the step of producing an imaging device using a stack obtained by the production method according to any one of the disclosure 13 to 15.

[Disclosure 17]

A method for producing an element, including the steps of:

forming an organic layer by forming a film of a curable resin composition on a surface of a substrate including an electrode, the surface being a surface including the electrode;

forming an inorganic layer having a compressive internal stress on the organic layer by chemical vapor deposition;
forming a through-hole in the organic layer and the inorganic layer;
filling the through-hole with a conductive material; and
forming a bonding electrode by polishing the surface of the substrate on the side where the through-hole is filled with the conductive material.

[Disclosure 18]

A method for producing an imaging device, including the step of producing an imaging device using an element obtained by the method for producing an element according to the disclosure 17.

[Disclosure 19]

A method for producing a semiconductor device, including the step of bonding two elements, each obtained by the method for producing an element according to the disclosure 17, such that the bonding electrodes are bonded to each other.

The stack of the present invention includes a first element, an organic layer on the first element, and an inorganic layer on the organic layer.

The organic and inorganic layers function as an insulating layer between elements or substrates in a semiconductor device including a stack of a plurality of elements or substrates. Conventional insulating layers are made of hard inorganic materials to withstand high-temperature treatment in production. They cannot relieve stress when an element deforms, and the element easily warps or cracks. The stack of the present invention includes an insulating layer containing a flexible organic compound capable of relieving stress, thereby suppressing warping and cracking of elements. As a result, misalignment or cracking of electrodes caused by warping or cracking of the elements can be suppressed, enhancing the connection reliability between the elements. Moreover, forming the inorganic layer as an auxiliary insulating layer on the organic layer makes the stack less permeable to atmospheric moisture as compared to the stack without the inorganic layer, thus leading to high connection reliability even under high-temperature, high-humidity conditions. Here, the organic compound constituting the organic layer encompasses organic-inorganic hybrid compounds, such as organosilicon compounds.

The first element is not limited and may be a circuit substrate provided with an element and a wire. For example, the first element may be a sensor circuit substrate provided with a pixel portion (pixel region), a circuit substrate mounted with a peripheral circuit portion such as a logic circuit that implements various types of signal processing related to the operation of a solid-state imaging device, or a circuit substrate mounted with a peripheral circuit portion such as a memory circuit, for example.

The organic layer is preferably a cured product of a curable resin composition.

When a curable resin composition is used as a material of the organic layer, the organic layer can be formed by applying the curable resin composition to form a film and curing the film. This can improve the production efficiency as compared to when a conventional inorganic material is used. The curable resin constituting the curable resin composition may be heat curable or photocurable. From the standpoint of heat resistance, the curable resin is preferably a heat curable resin.

The organic compound constituting the organic layer may be any organic compound with heat resistance to withstand high-temperature treatment performed at about 400°C for about four hours. Examples include organosilicon compounds and polyimides. In particular, the organic layer is preferably a cured product of a curable resin composition containing an organosilicon compound, because such an organic layer can achieve excellent heat resistance and flexibility and further suppress warping and cracking of elements to enhance the connection reliability.

The organosilicon compound is preferably silsesquioxane.

Silsesquioxane has flexibility equivalent to that of organic compounds and also has high heat resistance. Thus, use of an organic layer mainly containing silsesquioxane as an insulating layer in the stack can suppress warping and cracking of a substrate to enhance the electrical connection reliability. The silsesquioxane may be any heat curable silsesquioxane. To further suppress warping and cracking of a substrate, the silsesquioxane preferably has a structure represented by the following structural formula (A) or (B) in one molecule.

[Chem. 2]

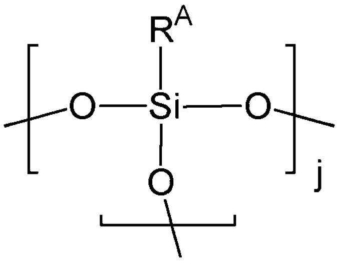 (A) 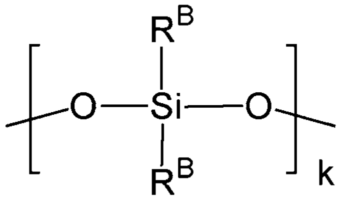 (B)

In the structural formula (A) or (B), $R^A$ and $R^B$ each independently represent an aliphatic group, an aromatic group, or hydrogen; and j and k each represent a repeating unit and the number thereof is an integer of 1 or greater.

The organosilicon compound preferably contains a reactive site.

Using a reactive site-containing organosilicon compound as a curable resin of the curable resin composition can further suppress warping and cracking of elements. Moreover, since organosilicon compounds have excellent heat resistance, the use of the organosilicon compound can further reduce the decomposition of the organic layer due to high-temperature treatment in the production of a semiconductor device including a stack of a plurality of stacks. Examples of the reactive site include a hydroxy group and an alkoxy group.

The amount of the reactive site-containing organosilicon compound in 100 parts by weight of the amount of the resin solids in the curable resin composition is preferably 80 parts by weight or more, more preferably 90 parts by weight or more, still more preferably 95 parts by weight or more. The amount of the reactive site-containing organosilicon compound in 100 parts by weight of the amount of the resin solids in the curable resin composition is preferably less than 100 parts by weight, more preferably 98 parts by weight or less.

The organosilicon compound preferably has a structure represented by the following formula (1).

With the organosilicon compound having a structure represented by the formula (1), warping of elements can be further suppressed. In particular, the organosilicon compound preferably further has an aromatic ring structure to further improve the heat resistance and further suppress warping and cracking of elements.

[Chem. 3]

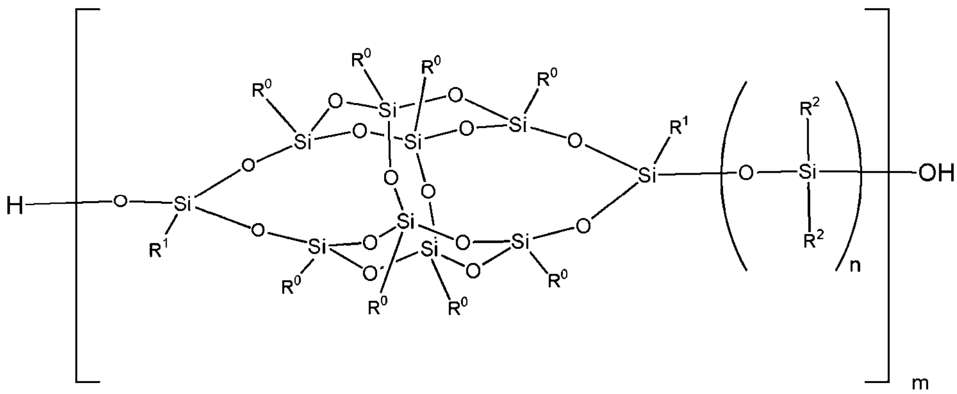 (1)

In the formula, $R^0$s, $R^1$s, and $R^2$s each independently represent a linear, branched, or cyclic aliphatic group, an aromatic group, or hydrogen; the aliphatic group and the aromatic group optionally have a substituent; and m and n each represent an integer of 1 or greater.

In the formula (1), $R^0$s each independently represent a linear, branched, or cyclic aliphatic group, an aromatic group, or hydrogen; the aliphatic group and the aromatic group optionally have a substituent; and $R^0$s are each preferably a phenyl group, a C1-C20 alkyl group, or an arylalkyl group, more preferably a phenyl group. When $R^0$s are each a phenyl group, a C1-C20 alkyl group, or an arylalkyl group, the silsesquioxane can have higher heat resistance.

In the formula (1), $R^1$s and $R^2$s each independently represent a linear, branched, or cyclic aliphatic group, an aromatic group, or hydrogen; the aliphatic group and the aromatic group optionally have a substituent; and $R^1$s and $R^2$s are each preferably a phenyl group, a C1-C20 alkyl group, or an arylalkyl group, more preferably a phenyl group or a methyl group. When $R^1$s and $R^2$s are each a phenyl group, a C1-C20 alkyl group, or an arylalkyl group, the silsesquioxane can have higher heat resistance.

In the formula (1), m and n are each an integer of 1 or greater and represent the number of repeating units; m is

preferably 30 or greater, more preferably 50 or greater and is preferably 100 or less; and n is preferably 1 or greater, more preferably 3 or greater, still more preferably 4 or greater and is preferably 8 or less, more preferably 6 or less.

The amount of the organosilicon compound in 100% by weight of the solid components in the curable resin composition is preferably 65% by weight or more and 99% by weight or less.

When the amount of the organosilicon compound in the solid components in the curable resin composition is within the range, warping and cracking of elements can be suppressed to further enhance the connection reliability between the elements. The amount of the organosilicon compound in 100% by weight of the solid components in the curable resin composition is more preferably 70% by weight or more, still more preferably 75% by weight or more and is more preferably 98% by weight or less, still more preferably 97% by weight or less.

The organosilicon compound may have any weight average molecular weight and preferably has a weight average molecular weight of 5,000 or greater and 150,000 or less. When the weight average molecular weight of the organosilicon compound is within the range, the film-forming properties in application can be increased to further enhance the planarizing properties. Moreover, warping and cracking of elements can be further suppressed. The weight average molecular weight of the organosilicon compound is more preferably 10,000 or greater, still more preferably 30,000 or greater and is more preferably 100,000 or less, still more preferably 70,000 or less.

The weight average molecular weight of the organosilicon compound is measured by gel permeation chromatography (GPC) as a polystyrene equivalent molecular weight. The weight average molecular weight can be calculated with polystyrene standards using THF as an elution solvent and HR-MB-M 6.0 × 150 mm (available from Waters Corporation) or its equivalent as a column.

The curable resin composition preferably contains a catalyst.

The catalyst functions to promote curing reaction. When the curable resin composition contains a catalyst, the curable resin composition can be more completely cured, which can further reduce the decomposition of the organic layer due to high-temperature treatment.

Examples of the catalyst include: organotin compounds such as dibutyltin dilaurate and tin(II) acetate; metal carboxylates such as zinc naphthenate; acetylacetonate complexes with zirconium as the central metal; and titanium compounds. Preferred among these are acetylacetonate complexes with zirconium as the central metal because they can further promote curing of the curable resin composition. The catalyst remains after the curable resin composition is cured. In other words, when the curable resin composition contains a catalyst, the resulting organic layer also contains the catalyst.

The amount of the catalyst is not limited and is preferably 0.01 parts by weight or more and 10 parts by weight or less relative to 100 parts by weight of the curable resin in the curable resin composition. When the amount of the catalyst is within the range, curing of the curable resin composition can be further promoted, which can further reduce the decomposition of the cured resin due to high-temperature treatment. The amount of the catalyst is more preferably 0.1 parts by weight or more, still more preferably 0.2 part by weight or more and is more preferably 7 parts by weight or less, still more preferably 5 parts by weight or less.

The curable resin composition preferably contains a crosslinking agent.

The crosslinking agent contained in the curable resin composition crosslinks the curable resin and increases the crosslinking density in the cured product, thereby further reducing the decomposition at high temperature. As a result, warping and cracking of elements can be suppressed, leading to higher connection reliability. Examples of the crosslinking agent include alkoxysilane compounds such as dimethoxysilane compounds, trimethoxysilane compounds, diethoxysilane compounds, and triethoxysilane compounds and silicate oligomers obtained by condensation of a tetramethoxysilane compound and a tetraethoxysilane compound. Preferred among these are polyalkoxysilanes from the standpoint of improving the crosslinking density and improving the heat resistance.

The amount of the crosslinking agent is not limited and is preferably 1 part by weight or more and 50 parts by weight or less relative to 100 parts by weight of the curable resin in the curable resin composition. When the amount of the crosslinking agent is within the range, the cured resin can have a crosslinking density within a suitable range. The amount of the crosslinking agent is more preferably 3 parts by weight or more, still more preferably 3.2 parts by weight or more and is more preferably 30 parts by weight or less, still more preferably 20 parts by weight or less.

The curable resin composition preferably contains a heat resistant resin.

When the curable resin composition contains a heat resistant resin, the cured film as the organic layer is less likely to crack in high-temperature treatment even with a large thickness.

Examples of the heat resistant resin include polyimides, epoxy resins, silicone resins, benzoxazine resins, cyanate resins, and phenolic resins. From the standpoint of heat resistance, polyimides are particularly preferred.

The heat resistant resin may have any weight average molecular weight and preferably has a weight average molecular weight of 5,000 or greater and 150,000 or less. When the weight average molecular weight of the heat resistant resin is within the range, the cured film as the organic layer is far less likely to crack in high-temperature treatment even with a large thickness. The molecular weight of the heat resistant resin is more preferably 10,000 or greater, still more preferably 30,000 or greater and is more preferably 100,000 or less, still more preferably 70,000 or less.

The amount of the heat resistant resin is preferably 0.5 parts by weight or more and 50 parts by weight or less relative to 100 parts by weight of the organosilicon compound.

When the amount of the heat resistant resin is within the range, the organic layer is far less likely to crack in high-temperature treatment even with a large thickness.

The amount of the heat resistant resin is more preferably 0.7 parts by weight or more, still more preferably 0.75 parts by weight or more, particularly preferably 1 part by weight or more and is more preferably 20 parts by weight or less, still more preferably 10 parts by weight or less, particularly preferably 5 parts by weight or less, relative to 100 parts by weight of the organosilicon compound.

When the heat resistant resin is a polyimide, the polyimide preferably has a siloxane bond.

When the polyimide has a siloxane bond, the compatibility of the polyimide with the organosilicon compound, if contained in the curable resin composition, is enhanced, so that irregularities (surface roughening) due to precipitation of the polyimide in application can be further reduced.

When the polyimide has a siloxane bond, the polyimide preferably has a ratio of carbon atoms to silicon atoms, C/Si, of 17 or less in the main chain structure.

When the ratio of carbon atoms to silicon atoms in the main chain of the polyimide is within the range, the compatibility of the polyimide with the organosilicon compound, if contained in the curable resin composition, is further enhanced, so that surface roughening in application can be further reduced. The C/Si is more preferably 16.5 or less, still more preferably 16 or less. The lower limit of the C/Si is not limited, but is preferably 4 or greater, from the standpoint of practical use and further enhancing the heat resistance at 400°C. Here, the ratio of carbon atoms to silicon atoms, C/Si, in the main chain structure of the polyimide is the ratio of C to Si in the repeating units and excludes C and Si at both terminals. The C/Si can be determined by obtaining the structure of the polyimide by 1H-NMR, 13C-NMR, and 29Si-NMR and measuring the number of C atoms and Si atoms from the repeating units of the main chain.

The polyimide preferably has a plurality of aromatic rings.

When the polyimide has a plurality of aromatic rings, the organic layer is less likely to crack in high-temperature treatment under various conditions even with a large thickness.

The polyimide preferably has an oxazine ring or imide ring structure at at least one terminal, more preferably both terminals.

The polyimide having an oxazine ring or imide ring structure at a terminal can further reduce surface roughening when a thick film is formed. The oxazine ring structure and the imide ring structure may have a substituent.

The polyimide still more preferably has a structure of any of the formulas (2) to (7) at at least one terminal, particularly preferably both terminals. Here, "*" in the formulas represents a linking site to a portion other than the terminal of the polyimide.

[Chem. 4]

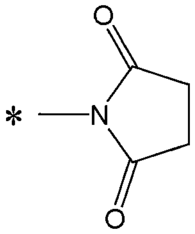 (2)

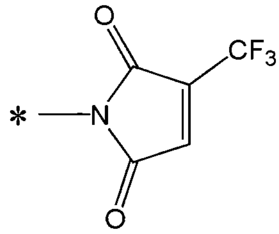 (3)

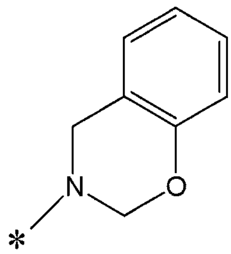 (4)

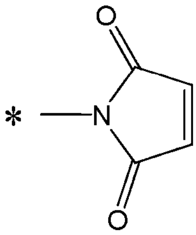 (5)

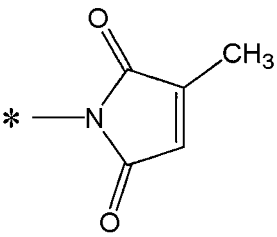 (6)

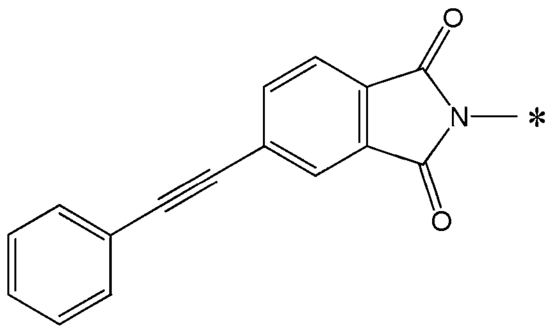 (7)

The polyimide preferably has a weight average molecular weight of 1,000 or greater and 50,000 or less.

When the weight average molecular weight of the polyimide is within the range, the compatibility of the polyimide with the organosilicon compound, if contained in the curable resin composition, can be improved, leading to higher handleability. The weight average molecular weight is more preferably 2,000 or greater, still more preferably 3,000 or greater and is more preferably 35,000 or less, still more preferably 30,000 or less.

The weight average molecular weight of the polyimide is measured by gel permeation chromatography (GPC) as a polystyrene equivalent molecular weight. The weight average molecular weight can be calculated with polystyrene standards using THF as an elution solvent and HR-MB-M 6.0 × 150 mm (available from Waters Corporation) or its equivalent as a column.

The amount of the polyimide is preferably 0.5 parts by weight or more and 50 parts by weight or less relative to 100 parts by weight of the organosilicon compound.

When the amount of the polyimide is within the range, the organic layer is far less likely to crack in high-temperature treatment even with a large thickness.

The amount of the polyimide is preferably 0.7 parts by weight or more, more preferably 0.75 parts by weight or more, still more preferably 1 part by weight or more and is preferably 20 parts by weight or less, more preferably 10 parts by weight or less, still more preferably 5 parts by weight or less, relative to 100 parts by weight of the organosilicon compound.

The curable resin composition may contain other additives such as solvents, viscosity modifiers, fillers, or adhesion promoters as needed.

The organic layer preferably has a thickness of 10 μm or greater.

When the thickness of the organic layer is within the range, the organic layer can function as an insulating layer while suppressing warping and cracking of elements to enhance the connection reliability. A conventional stack including an inorganic layer on an organic layer is susceptible to cracking in the inorganic layer especially when the organic layer is thick. In contrast, the stack of the present invention is less susceptible to cracking in the inorganic layer even when the organic layer is thick, thus exhibiting high moisture resistance. The thickness of the organic layer is preferably 20 μm or greater, more preferably 30 μm or greater and is preferably 200 μm or less, more preferably 100 μm or less.

The organic layer may contain component(s) other than the organic compound, the main component of the organic layer, as long as the effects of the present invention are not significantly impaired. In this case, the amount of the

organic compound, the main component of the organic layer, is for example preferably 90% by weight or more, more preferably 95% by weight or more, still more preferably 99% by weight or more, typically less than 100% by weight.

The organic layer has a 1% thermal weight loss temperature of 400°C or higher as measured at a temperature increase rate of 10°C/min under a nitrogen atmosphere.

When the 1% thermal weight loss temperature of the organic layer is 400°C or higher, decomposition of the organic layer can be reduced in high-temperature treatment, and the occurrence of interfacial bubbles or cracks or interfacial delamination can be further reduced. Moreover, degradation of CVD film quality or contamination of CVD devices due to outgassing from the organic layer can be reduced. The 1% thermal weight loss temperature is preferably 420°C or higher, more preferably 440°C or higher, still more preferably 460°C or higher. The upper limit of the 1% thermal weight loss temperature is not limited and preferably as high as possible. For example, the upper limit is 500°C. The 1% thermal weight loss temperature of the organic layer can be adjusted by the type of the organic compound, which is the main component of the organic layer, or the additives to be compounded. For example, it can be adjusted by the type and amount of the curing-promoting catalyst to be compounded, the type and amount of an additive for reducing thermal decomposition to be compounded, and/or the like. The 1% thermal weight loss temperature can be measured using a simultaneous differential thermogravimetric analyzer (TG-DTA; STA7200, available from Hitachi High-Technologies Corporation or its equivalent) under 50 mL/min nitrogen flow at a temperature increase rate of 10°C/min.

The inorganic layer includes a $Si_3N_4$ layer.

Using $Si_3N_4$ as the inorganic layer enhances the moisture resistance and reduces the moisture intrusion into the organic layer and electrodes, leading to higher connection reliability. In a conventional semiconductor device including a stack of a plurality of substrates including electrodes, the insulating layers include only inorganic layers. The insulating layers thus cannot eliminate warping of elements, leading to cracking of elements or a decrease in the connection reliability. In the stack of the present invention, the insulating layer is mostly composed of the organic layer, and the thickness of the inorganic layer is minimized. The insulating layer thus can eliminate warping of elements while enhancing the moisture resistance. The thickness of the $Si_3N_4$ layer is preferably 50 nm or greater, more preferably 100 nm or greater and is preferably 500 nm or less, more preferably 300 nm or less.

The $Si_3N_4$ layer herein refers to a layer with stoichiometric N/Si ratio = about 1 to 2 (theoretical N/Si ratio = 1.33). Hereinafter the $Si_3N_4$ layer may be referred to as a SiN layer or SiN film.

Preferably, the inorganic layer includes a $SiO_2$ layer, and the $Si_3N_4$ layer is on the $SiO_2$ layer.

When the inorganic layer further includes the $SiO_2$ layer and the $Si_3N_4$ layer is on the $SiO_2$ layer, in other words, when the organic layer, $SiO_2$ layer, and $Si_3N_4$ layer are stacked in this order, the moisture resistance can be further enhanced. The thickness of the $SiO_2$ layer is preferably 50 nm or greater, more preferably 100 nm or greater and is preferably 500 nm or less, more preferably 300 nm or less.

The inorganic layer has a thickness of 1 nm or greater and 1 $\mu$m or less.

When the thickness of the inorganic layer is within the range, the moisture resistance can be enhanced while allowing the organic layer to maintain the effect of suppressing warping of elements. The thickness of the inorganic layer is preferably 50 nm or greater, more preferably 100 nm or greater and is preferably 700 nm or less, more preferably 400 nm or less, from the standpoint of the stability of the inorganic film quality.

The inorganic layer has a compressive internal stress.

Studies have been made on forming a thin inorganic layer on an organic layer and thereby providing an insulating layer with flexibility and moisture resistance. Unfortunately, merely forming an inorganic layer on an organic layer may result in cracking of the inorganic layer, leading to insufficient improvement of the moisture resistance. In the present invention, the inorganic layer is formed such that a compressive internal stress occurs. This can reduce the difference in internal stress between the inorganic and organic layers, thus suppressing cracking of the inorganic layer and thereby imparting sufficient moisture resistance. Since the present invention is highly effective in suppressing cracking of inorganic layers, it is particularly highly effective when a thick inorganic layer, which easily cracks, is used. The inorganic layer having a compressive internal stress can be obtained by forming the inorganic layer by chemical vapor deposition (CVD) while adjusting the forming conditions. Specifically, it can be obtained by employing plasma-enhanced CVD and adjusting conditions such as plasma deposition temperature, chamber internal pressure, applied power, or how often the RF frequencies are switched. Among CVD methods, plasma-enhanced CVD allows deposition at relatively low temperature, thus allowing deposition of the inorganic layer on the organic layer with less damage to the organic layer due to heat or the like during the CVD process. Note that the inorganic layer having a compressive internal stress is obtained by intentionally adjusting the above conditions, and difficult to form without the intention of providing a compressive internal stress to the inorganic layer.

Having a compressive internal stress means that the inorganic layer deposited on an element has a stress that tends to stretch the layer toward the outside from the center in parallel with a plane direction (direction perpendicular to a thickness direction) of the element at normal temperature with no external force applied thereto. Conversely, if the inorganic layer has a stress that tends to contract the layer toward the center from the outside in parallel with a plane direction of an element at normal temperature with no external force applied thereto, the inorganic layer is defined as

having a tensile internal stress. When the inorganic layer includes a plurality of layers, having a compressive internal stress means that each of the layers has a compressive internal stress. The internal stress can be measured by the following method.

The amount of warping and curvature radius of an untreated silicon wafer are calculated using a film stress meter (FLX2320-S, available from Toho Technology Corporation, or its equivalent). The curvature radius R at this time is designated $R_1$. Subsequently, a 100-nm inorganic film is deposited on the silicon wafer having the calculated curvature radius using PE-CVD (MPX-CVD, available from Sumitomo Precision Products Co., Ltd., or its equivalent). After the inorganic film is deposited, the amount of warping and curvature radius are calculated again using the film stress meter. The curvature radius R at this time is designated $R_2$. Based on the change in curvature radius before and after the inorganic film deposition, the internal stress S (Pa) of the inorganic film is calculated using Stoney's equation represented by the following equation (A).

[Math 1]

$$S = \frac{Eh^2}{(1-v)\,6Rt} \cdots \quad (A)$$

The details of the equation (A) are as follows.

E/(1-v): biaxial elastic modulus (Pa) of silicon wafer, $1.805 \times 10^{11}$ Pa
h: thickness (m) of silicon wafer, 725 μm
t: thickness (m) of inorganic film, 100 nm
R: curvature radius of substrate, determined using equation (B) below
[Math. 2]

$$\frac{1}{R} = \frac{1}{R_2} - \frac{1}{R_1} \cdots \quad (B)$$

In the equation (A), a negative value of the internal stress S indicates that the inorganic film has a compressive internal stress, whereas a positive value indicates that it has a tensile internal stress. Thus, the inorganic layer in the present invention has an internal stress S of less than 0 MPa. The internal stress is preferably -50 MPa or less, more preferably -100 MPa or less, still more preferably -150 MPa or less, from the standpoint of preventing cracking while taking into account the temperature dependency that the internal stress shifts toward positive values at high temperature. The internal stress is preferably -400 MPa or greater, more preferably - 350 MPa or greater, still more preferably -300 MPa or greater, from the standpoint of reducing wrinkling caused by internal stress and improving the appearance.

Specific examples of the conditions for imparting a compressive internal stress to the inorganic layer in CVD are as follows. The plasma deposition temperature is preferably 250°C or higher, more preferably 300°C or higher, still more preferably 350°C or higher and is preferably 500°C or lower, more preferably 450°C or lower, still more preferably 400°C or lower.

Since the higher the internal chamber pressure is, the more easily the inorganic layer has a tensile internal stress, the chamber internal pressure is preferably 50 Pa or greater, more preferably 100 Pa or greater, still more preferably 130 Pa or greater and is preferably 200 Pa or less, more preferably 160 Pa or less, still more preferably 150 Pa or less.

The applied power and the RF frequency are parameters for generating plasma, which acts as the trigger to activate chemical species and allow them to react and grow on the organic film. The RF frequency is often a high frequency of 13.56 MHz (HF) alone, but it may be combined with a low frequency of 380 kHz (LF).

In imparting a compressive internal stress to the inorganic layer, voltage is preferably applied at a low RF frequency of 380 kHz alone. In combining 380 kHz and 13.56 MHz, an application time T1 at 13.56 MHz and an application time T2 at 380 kHz preferably satisfy the relation T2 > T1, more preferably T2 > 3 × T1, still more preferably T2 > 6 × T1, and preferably T2 < 20 × T1, more preferably T2 < 15 × T1, still more preferably T2 < 12 × T1.

The applied power is preferably 20 W or greater, more preferably 30 W or greater, still more preferably 50 W or greater and is preferably 200 W or less, more preferably 100 W or less, still more preferably 60 W or less, at 13.56 MHz (HF) and 380 kHz (LF). HF and LF may be the same as or different from each other.

The first element may have a first surface and a second surface. The first surface may include a plurality of chips. The organic and inorganic layers may be on the first surface side.

When the first element has a plurality of chips thereon and has conventional organic and inorganic layers on the surface with the chips, the chips form irregularities. This leads to a non-flat bonding surface of the organic layer in bonding the element with another stack or substrate via the organic and inorganic layers, and tends to reduce the connection reliability. In the stack of the present invention, even such an element with large irregularities can exhibit high connection

reliability as the organic layer fills the irregularities and planarizes the bonding surface, and warping and cracking of the first element and chips can be suppressed.

Examples of the chips include memory circuit elements and logic circuit elements. The number of chips may be any number of two or more.

The stack of the present invention may further include a supporting substrate on the inorganic layer.

Stacking the supporting substrate on the inorganic layer facilitates securing an electronic component including the stack of the present invention (e.g., an imaging device, a semiconductor device) to a housing.

Examples of the supporting substrate include glass and monocrystalline silicon.

When the organic layer is a cured product of a curable resin composition containing the silsesquioxane or the organosilicon compound having a structure represented by the formula (1), the stack of the present invention preferably satisfies $P2180/P775 < 0.045$, where P775 is a peak height at 775 $cm^{-1}$ (Si-O) and P2180 is a peak height at 2,180 $cm^{-1}$ (Si-H) in an IR spectrum measured from a surface of the inorganic layer by FT-IR.

The peak at 775 $cm^{-1}$ indicates the presence of silicon-oxygen bonds. The peak at 2,180 $cm^{-1}$ indicates the presence of silicon-hydrogen bonds.

Since silicon-hydrogen bonds are easily permeable to moisture, a high silicon-hydrogen bond content may decrease the moisture resistance. Thus, P2180/P775 within the above range, in other words, a lower silicon-hydrogen bond content than the silicon-oxygen bond content, can further enhance the moisture resistance of the inorganic layer and the stack. P2180/P775 is more preferably less than 0.04, still more preferably less than 0.03. The lower limit of P2180/P775 is not limited and preferably as low as possible. The lower limit is usually greater than 0. P2180/P775 can be adjusted by the deposition conditions of the inorganic layer.

Here, the Si-O bond peak is detected because infrared light penetrates to a depth of 2 to 3 μm near the surface in measuring the IR spectrum by FT-IR and allows detection of Si-O in the underlying organic layer. Meanwhile, the Si-H peak is detected because during the reaction of depositing the SiN film or $SiO_2$ film by CVD, the raw material SiH is not completely converted to $Si_3N_4$ or $SiO_2$ and leaves Si-H bonds derived from the raw material SiH.

When the organic layer is a cured product of a curable resin composition containing the silsesquioxane or the organosilicon compound having a structure represented by the formula (1), the stack of the present invention preferably satisfies $P1200/P775 < 0.300$, where P775 is a peak height at 775 $cm^{-1}$ (Si-O) and P1200 is a peak height at 1,200 $cm^{-1}$ (N-H) in an IR spectrum measured from a surface of the inorganic layer by FT-IR.

The peak at 775 $cm^{-1}$ indicates the presence of silicon-oxygen bonds. The peak at 1,200 $cm^{-1}$ indicates the presence of nitrogen-hydrogen bonds.

Since nitrogen-hydrogen bonds are easily permeable to moisture and constitute impurities in the SiN film, a high nitrogen-hydrogen bond content may decrease the moisture resistance or cause change in performance at high temperature. Thus, P1200/P775 within the above range, in other words, a lower nitrogen-hydrogen bond content than the silicon-oxygen bond content, can further enhance the moisture resistance of the inorganic layer and the stack. P1200/P775 is more preferably less than 0.28, still more preferably less than 0.25. The lower limit of P1200/P775 is not limited and preferably as low as possible. The lower limit is usually greater than 0. P1200/P775 can be adjusted by the deposition conditions of the inorganic layer.

Here, the Si-O bond peak is detected because infrared light penetrates to a depth of 2 to 3 μm near the surface in measuring the IR spectrum by FT-IR and allows detection of Si-O in the underlying organic layer. Meanwhile, the N-H bond peak is detected because during the reaction of depositing the SiN film by CVD, the raw material $NH_3$ or raw material gas is not completely converted to $Si_3N_4$ and leaves N-H bonds derived from the raw material $NH_3$ or raw material gas.

Specifically, P2180/P775 and P1200/P775 can be measured by the following method.

An element provided with the deposited inorganic layer is analyzed by attenuated total reflectance (ATR) Fourier transform infrared (FT-IR) spectroscopy to measure an absorption spectrum. The measurement is performed in a measurement range from 525 $cm^{-1}$ to 4,000 $cm^{-1}$ and a resolution of 4 $cm^{-1}$. In the obtained absorption spectrum, the peak height at 775 $cm^{-1}$ (Si-O) is defined as P775, the peak height at 2,180 $cm^{-1}$ (Si-H) is defined as P2180, and the peak height at 1,200 $cm^{-1}$ (N-H) is defined as P1200. P2180 or P1200 is divided by P775 to give P2180/P775 or P1200/P775.

FIG. 1 is a schematic view of an example of the stack of the present invention. As shown in FIG. 1, the stack of the present invention includes a first element 1 and includes an organic layer 2 and an inorganic layer 3 on the first element 1. The organic layer 2 and the inorganic layer 2 function as an insulating layer when a plurality of stacks are stacked. A conventional stack including an insulating layer made of an organic compound is highly effective in suppressing warping of elements due to heating treatment when a plurality of stacks are stacked to form a semiconductor device. However, such a stack is easily permeable to atmospheric moisture. The stack of the present invention includes the thin inorganic layer 3 containing $Si_3N_4$ on the organic layer 2 and thereby can reduce the moisture penetration. Further, in the stack of the present invention, the inorganic layer 3 has a compressive internal stress. This reduces the difference in internal stress between the organic layer 2 and the inorganic layer 3, suppressing cracking of the inorganic layer. As a result, the stack is less permeable to moisture and thus can exhibit high connection reliability. Here, in the stack of the present invention, the inorganic layer 3 is thin and thus does not hinder the organic layer 2 from eliminating warping of elements. Although FIG. 1

depicts the organic layer 2 and the inorganic layer 3 as single layers, they may be composed of a plurality of layers.

FIGs. 2 and 3 are each a schematic view of an example of the stack of the present invention. As shown in FIG. 2, the stack of the present invention may include a plurality of chips 4 on one surface (first surface) of the first element 1 and include the organic layer 2 and the inorganic layer 3 on the first surface of the first element 1. As shown in FIG. 3, a supporting substrate 5 may be stacked on the inorganic layer 3.

The present invention also encompasses a method for producing the stack of the present invention, including the steps of: forming the organic layer by forming a film of a curable resin composition on a first element; and forming the inorganic layer having a compressive internal stress on the organic layer by chemical vapor deposition.

The method for producing the stack of the present invention first conducts the step of forming the organic layer by forming a film of a curable resin composition on a first element.

In a conventional stack including an insulating layer made of an inorganic material, the insulating layer is produced using a time-consuming method such as chemical vapor deposition (CVD) or sputtering. In the stack of the present invention, the insulating layer is mainly composed of an organic compound and can be produced by applying and drying a solution, enabling higher production efficiency in addition to improved connection reliability. The first element and curable resin composition are the same as those in the stack of the present invention.

The film forming method is not limited and may be a conventionally known method such as spin coating.

The conditions for removing the solvent by drying are not limited. From the standpoint of reducing the residual solvent and improving the heat resistance of the organic layer, heating is preferably performed at a temperature of 70°C or higher, more preferably 100°C or higher and preferably 250°C or lower, more preferably 200°C or lower for, for example, 30 minutes, more preferably about one hour.

The curing conditions are not limited. From the standpoint of allowing the curing reaction to sufficiently proceed and further improving heat resistance, heating is preferably performed at a temperature of preferably 200°C or higher, more preferably 220°C or higher and preferably 400°C or lower, more preferably 300°C or lower for, for example, one hour or longer, more preferably about two hours or longer. The upper limit of the heating time is not limited. From the standpoint of reducing thermal decomposition of the organic layer, the upper limit is preferably three hours or shorter.

In the method for producing the stack of the present invention, preferably, the first element has a first surface and a second surface, the first surface includes a plurality of chips, and the organic layer is formed on the first surface side in the step of forming the organic layer.

Forming the organic layer by such a step and then forming the inorganic layer described later can provide a stack with the structure shown in FIG. 2.

The method for producing the stack of the present invention subsequently conducts the step of forming the inorganic layer having a compressive internal stress on the organic layer by chemical vapor deposition.

The inorganic layer having a compressive internal stress can be obtained by forming an inorganic layer on the organic layer by chemical vapor deposition (CVD) while adjusting the conditions in the CVD. The inorganic layer and the CVD conditions are the same as the inorganic layer and the specific CVD conditions for the stack of the present invention.

The method for producing the stack of the present invention preferably further includes the step of bonding a supporting substrate onto the inorganic layer.

Conducting the step of bonding the supporting substrate can provide a stack with the structure shown in FIG. 3.

The stack of the present invention can be used in any applications. Since the stack is less susceptible to warping and cracking of elements when a plurality of the stacks are stacked, has high moisture resistance, and can impart excellent connection reliability, the stack is suitable for imaging devices and semiconductor devices. The present invention also encompasses an imaging device including the stack of the present invention, a semiconductor device including the stack of the present invention, and a method for producing an imaging device including the step of producing an imaging device using a stack obtained by the method for producing the stack of the present invention.

The stack of the present invention may also be used as a material of an element including a stack of a plurality of stacks.

The present invention also encompasses a method for producing an element, including the steps of: forming an organic layer by forming a film of a curable resin composition on a surface of a substrate including an electrode, the surface being a surface including the electrode; forming an inorganic layer having a compressive internal stress on the organic layer by chemical vapor deposition; forming a through-hole in the organic layer and the inorganic layer; filling the through-hole with a conductive material; and forming a bonding electrode by polishing the surface of the substrate on the side where the through-hole is filled with the conductive material.

The method for producing an element of the present invention first conducts the step of forming an organic layer by forming a film of a curable resin composition on a surface of a substrate including an electrode, the surface being a surface including the electrode; and forming an inorganic layer having a compressive internal stress on the organic layer by chemical vapor deposition.

The steps of forming an organic layer and forming an inorganic layer are the same as those in the method for producing the stack of the present invention.

The substrate including an electrode is not limited and may be a circuit substrate provided with an element, a wire, and an electrode. For example, the substrate may be a sensor circuit substrate provided with a pixel portion (pixel region) or a circuit substrate mounted with a peripheral circuit portion such as a logic circuit that implements various types of signal processing related to the operation of a solid-state imaging device, for example.

Th electrode of the substrate including an electrode may be composed of any material, such as gold, copper, aluminum, or other conventionally known electrode material.

The method for producing an element of the present invention subsequently conducts the step of forming a through-hole in the organic layer and the inorganic layer.

The organic and inorganic layers on the electrode of the substrate are removed to form a through-hole, which is filled with a conductive material. Thus, a bonding electrode for connection with another substrate is formed. The through-hole may be patterned. The method for forming the through-hole is not limited. The through-hole can be formed by laser irradiation such as $CO_2$ laser irradiation or etching. When a different layer is formed on an electrode surface of the substrate, the through-hole is formed to extend through the different layer as well as the organic and inorganic layers so that the electrode surface of the element is exposed.

The method for producing an element of the present invention subsequently conducts the step of forming a barrier metal layer, if necessary.

The barrier metal layer serves to prevent the conductive material (e.g., Cu atoms in the case of Cu electrode) filling the through-hole from diffusing into the organic layer. The barrier metal layer provided on the surface of the through-hole covers the conductive material filling the through-hole except for the surfaces that contact the electrodes. This can further reduce short circuiting and conduction failure caused by the diffusion of the conductive material into the organic layer. The barrier metal layer can be formed by sputtering or vapor deposition, for example.

The material of the barrier metal layer may be a known material such as tantalum, tantalum nitride, titanium nitride, silicon oxide, or silicon nitride.

The barrier metal layer may have any thickness. To further increase the connection reliability of the stack, the barrier metal layer more preferably has a thickness of 1 nm or greater, still more preferably 10 nm or greater, while more preferably 100 nm or less, still more preferably 50 nm or less.

The method for producing an element of the present invention subsequently conducts the step of filling the through-hole with a conductive material. The method of filling the through-hole with the conductive material may be plating, for example.

The conductive material may be the same as the material of the electrode of the substrate including an electrode in the stack of the present invention.

The method for producing an element of the present invention subsequently conducts the step of forming a bonding electrode by polishing the surface of the substrate on the side where the through-hole is filled with the conductive material.

Polishing removes the conductive material on undesired portions, whereby a bonding electrode for connection with an electrode of another element is formed. The polishing preferably planarizes and removes the layer made of the conductive material until the inorganic layer is exposed.

The method for polishing is not limited and may be a chemical mechanical polishing method, for example.

The element obtained by the method for producing an element of the present invention may be used in any applications. The element is suitable for an imaging device including a semiconductor device including a stack of elements. The present invention also encompasses a method for producing an imaging device, including the step of producing an imaging device using an element obtained by the method for producing an element of the present invention.

The element obtained by the method for producing an element of the present invention is used for producing a semiconductor device including a plurality of elements stacked via bonding electrodes.

The present invention also encompasses a method for producing a semiconductor device, including the step of bonding two elements, each obtained by the method for producing an element of the present invention, such that the bonding electrodes are bonded to each other.

In the step of bonding the elements such that the bonding electrode are bonded to each other, the bonding electrodes may be bonded by melting the electrodes and the bonding electrodes by heat treatment. The heat treatment is typically performed at about 400°C for about four hours.

FIG. 4 is a schematic view of an example of a semiconductor device obtained by the method for producing a semiconductor device of the present invention. As shown in FIG. 4, a semiconductor device obtained by the method for producing a semiconductor of the present invention includes substrates 6 and 10 including electrodes 7. The substrates 6 and 10 are bonded via organic layers 2 and inorganic layers 3. The electrodes 7 on the substrates 6 and 10 including electrodes 7 are electrically connected via a conductive material filling the through-holes 8 in the organic layers 2 and the inorganic layers 3. Covering the organic layers 2 with thin inorganic layers 3 can improve the moisture resistance as compared to when the organic layers 2 are used alone, leading to higher connection reliability. The semiconductor device may include barrier metal layers 9 on the surfaces of the through-holes 8. Forming the barrier metal layers 9 on the surfaces

of the through-holes 8 makes it difficult for the conductive material filling the through-holes 8 to diffuse into the organic layers 2, and thus can further reduce short circuiting and conduction failure.

- Advantageous Effects of Invention

The present invention can provide a stack that, when a plurality of the stacks are stacked, can provide a semiconductor device in which elements are less likely to warp or crack, that has high moisture resistance, and that can impart excellent connection reliability, a method for producing the stack, a method for producing an element using the stack, an imaging device including the stack, a method for producing the imaging device, a semiconductor device including the stack, and a method for producing the semiconductor device.

BRIEF DESCRIPTION OF DRAWINGS

FIG. 1 is a schematic view of an example of the stack of the present invention.
FIG. 2 is a schematic view of an example of the stack of the present invention.
FIG. 3 is a schematic view of an example of the stack of the present invention.
FIG. 4 is a schematic view of an example of a semiconductor device obtained by the method for producing a semiconductor device of the present invention.

DESCRIPTION OF EMBODIMENTS

Embodiments of the present invention are more specifically described in the following with reference to examples. The present invention, however, is not limited to these examples.

(Example 1)

(1) Production of organosilicon compound A

A reaction vessel equipped with a reflux condenser, a thermometer, and a dropping funnel was charged with 65.4 g of phenyltrimethoxysilane (available from Tokyo Chemical Industry Co., Ltd., molecular weight 198.29), 8.8 g of sodium hydroxide, 6.6 g of water, and 263 mL of 2-propanol. Heating was started under a nitrogen gas flow with stirring. Stirring was continued for six hours from the start of reflux, and the mixture was then left to stand overnight at room temperature. The reaction mixture was transferred into a filter and filtered by pressurization with nitrogen gas. The obtained solid was washed with 2-propyl alcohol once, filtered, and then dried at 80°C under reduced pressure to give 33.0 g of a colorless solid (DD-ONa).

A three-neck flask equipped with a dropping funnel, a reflux condenser, and a thermometer and having an inner capacity of 300 ml was charged with 11.6 g of the compound (DD-ONa), 100 g of tetrahydrofuran, and 3.0 g of triethylamine, and sealed with dry nitrogen. With stirring using a magnetic stirrer, 4.5 g (30 mmol) of methyltrichlorosilane was added dropwise at room temperature. The mixture was then stirred for three hours at room temperature. To the reaction solution was added 50 g of water to dissolve the produced sodium chloride and hydrolyze unreacted methyltrichlorosilane. The resulting reaction mixture was separated into layers, and the organic layer was washed with 1 N hydrochloric acid once and with a saturated sodium hydrogen carbonate aqueous solution once, and further water-washed with ion-exchanged water three times. The washed organic layer was dried with anhydrous magnesium sulfate and concentrated under reduced pressure using a rotary evaporator, whereby 7.1 g of white powdery solid (DD(Me)-OH) was obtained.

A condenser, a mechanical stirrer, a Dean-Stark trap, an oil bath, and a thermometer protecting tube were attached to a 100-mL flask. The air inside the flask was purged with nitrogen. The flask was charged with 5.0 g of DD(Me)-OH, 11.6 g of octamethylcyclotetrasiloxane (D4), 3.9 g of sulfuric acid, 52 g of toluene, and 13 g of 4-methyltetrahydropyran. After stirring at 100°C for five hours, water was poured to the reaction mixture, and the aqueous layer was extracted with toluene. The combined organic layers were washed with a sodium hydrogen carbonate aqueous solution and saturated saline, and then dried with anhydrous sodium sulfate. This solution was concentrated under reduced pressure. The residue was purified by reprecipitation in a solution containing 2-propanol and ethyl acetate at 50:7 (weight ratio) and dried. Thus, an organosilicon compound A (weight average molecular weight: 36,000) having a structure of the following formula (8) with m being 27 and n being 4 on average was obtained.

[Chem. 5]

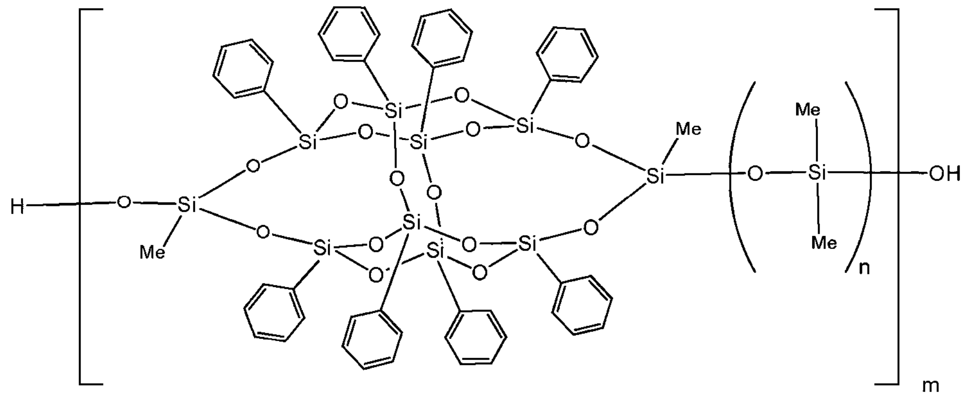

(8)

(2) Production of additive A

A condenser, a mechanical stirrer, a Dean-Stark trap, an oil bath, and a thermometer protecting tube were attached to a 100-mL flask. The flask was charged with 11.1 g of 4,4'-(hexafluoroisopropylidene)diphthalic anhydride (6FDA) (available from Daikin Industries, Ltd.), 7.8 g of bisaminopropyltetramethyldisiloxane (PAM-E, Shin-Etsu Chemical Co., Ltd.), and 92.1 g of anisole, and they were stirred. The flask was heated at 100°C for one hour, followed by reflux in an oil bath at 170°C for one hour. The solution was cooled to room temperature, and 1.3 g of citraconic anhydride (available from Tokyo Chemical Industry Co., Ltd.) was added. The solution was stirred at 120°C for 10 minutes and then refluxed for one hour in an oil bath at 170°C, whereby an additive A (weight average molecular weight: 9,900) having a structure of the following formula (9) was obtained. In the formula (9), l represents the number of repeating units.

[Chem. 6]

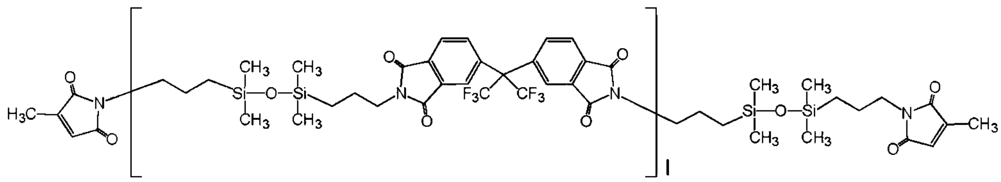

(9)

(3) Production of curable resin composition

A solvent (cyclopentanone, available from Tokyo Chemical Industry Co., Ltd.) was added to 100 parts by weight of the obtained organosilicon compound, 0.2 parts by weight of a catalyst (ZC-162, acetylacetonate complex with zirconium as the central metal, available from Matsumoto Fine Chemical Co., Ltd.), 3.2 parts by weight of a crosslinking agent (Methyl Silicate 51, available from Colcoat Co., Ltd.), and 1 part by weight of the additive A such that the amount of the solvent was 65% by weight. Thus, a curable resin composition was obtained.

(4) Production of stack

An amount of 15 g of the obtained curable resin composition was ejected onto a center portion of an 8-inch silicon wafer (surface roughness < 0.1 μm). Spin coating was then performed using a spin coater (ACT-400II, available from Active, Ltd.) at a rotation rate of 500 rpm for 12 seconds. The solvent was removed by drying in an oven at 125°C for 10 minutes, whereby an 85-μm resin film was obtained. The resin film was heat-treated at 300°C for one hour to form an organic layer. The obtained silicon wafer provided with the organic layer was heat-treated for one hour under a nitrogen atmosphere at 400°C using Rapid Thermal Vacuum Process Oven (VPO-650, available from UniTemp). Subsequently, inorganic film deposition was performed by CVD for a predetermined time under the conditions shown in Table 3 using PE-CVD (product number MPX-CVD, available from Sumitomo Precision Products Co., Ltd.). Thus, a SiN layer (inorganic layer) with a thickness of 400 nm was formed on the organic layer, whereby a stack was obtained. In Table 3, "HF" in the "Upper RF power" column represents the power in deposition at 13.56 MHz, and "LF" represents the power in deposition at 380 kHz. In the "Switching mode" column, "First" means that the frequency was applied first and "End" means that the frequency was applied later when the frequency alternated between 13.56 MHz and 380 kHz. In the "Film stress" column,

"Compressive" represents compressive stress, and "Tensile" represents tensile stress.

(5) Measurement of 1% thermal weight loss temperature

A single organic layer was produced by the method described above. The single layer was heated using a simultaneous differential thermogravimetric analyzer (TG-DTA; STA7200, available from Hitachi High-Technologies Corporation) under 50 mL/min nitrogen flow at a temperature increase rate of 10°C/min. The temperature at which the weight loss reached 1% was measured. Table 1 shows the results.

(6) Measurement of internal stress

The amount of warping and curvature radius of an untreated silicon wafer were calculated using a film stress meter (FLX2320-S, available from Toho Technology Corporation). The curvature radius R at this time was designated $R_1$. Subsequently, a 100-nm inorganic film was deposited on the silicon wafer having the calculated curvature radius using PE-CVD (product number MPX-CVD, available from Sumitomo Precision Products Co., Ltd.) under the conditions shown in Table 2. After the inorganic film was deposited, the amount of warping and curvature radius were calculated again using the film stress meter. The curvature radius R at this time was designated $R_2$. From the change in curvature radius before and after the inorganic film deposition, the inorganic film stress S (Pa) was calculated using Stoney's equation represented by the following equation (A). Table 1 shows the results. In the table, a negative value of the film stress indicates that the inorganic film had a compressive internal stress, whereas a positive value indicates that it had a tensile internal stress.
[Math 3]

$$S = \frac{Eh^2}{(1-v)\,6Rt} \cdots \quad (A)$$

The details of the equation (A) are as follows:

E/(1-v): biaxial elastic modulus (Pa) of silicon wafer, $1.805 \times 10^{11}$ Pa
h: thickness (m) of silicon wafer, 725 μm
t: thickness (m) of inorganic film, 100 nm
R: curvature radius of substrate, determined using equation (B) below
[Math. 4]

$$\frac{1}{R} = \frac{1}{R_2} - \frac{1}{R_1} \cdots \quad (B)$$

(7) Measurement of P2180/P775 and P1200/P775

A substrate provided with the deposited inorganic film was analyzed by attenuated total reflectance (ATR) Fourier transform infrared (FT-IR) spectroscopy to measure an absorption spectrum. The measurement was performed in a measurement range from 525 $cm^{-1}$ to 4,000 $cm^{-1}$ and a resolution of 4 $cm^{-1}$. In the obtained absorption spectrum, the peak height at 775 $cm^{-1}$ (Si-O) was defined as P775, and the peak height at 2,180 $cm^{-1}$ (Si-H) was defined as P2180. P2180 was divided by P775 to give P2180/P775. Similarly, the peak height at 1,200 $cm^{-1}$ (N-H) was defined as P1200. P1200 is divided by P775 to give P1200/P775.

(Examples 2 to 19 and Comparative Examples 1 to 6)

Stacks were obtained as in Example 1 except that the structure and film forming conditions of the organic and inorganic layers were as shown in Tables 1 to 3. The 1% thermal weight loss temperature, internal stress, P2180/P775, and P1200/P775 were measured. In Comparative Example 6, the catalyst was dibutyltin dilaurate (available from Tokyo Chemical Industry Co., Ltd.). In Examples 16, 18, and 19, the crosslinking agent was Ethyl Silicate 48 (available from Colcoat Co., Ltd.). The resin B and additives B to D were ones obtained by the method described below or commercial products. In the deposition conditions 10 to 12, the deposition device was PD-220NL (available from Samco)

(Production of resin B)

A condenser, a mechanical stirrer, a Dean-Stark trap, an oil bath, and a thermometer protecting tube were attached to a 100-mL flask. The air inside the flask was purged with nitrogen. The flask was charged with 5.0 g of the DD(Me)-OH, 11.2 g of octamethylcyclotetrasiloxane (D4), 3.9 g of sulfuric acid, 52.0 g of toluene, and 13.0 g of 4-methyltetrahydropyran. After stirring at 100°C for five hours, water was poured to the reaction mixture, and the aqueous layer was extracted with toluene. The combined organic layers were washed with a sodium hydrogen carbonate aqueous solution and saturated saline, and then dried with anhydrous sodium sulfate. This solution was concentrated under reduced pressure. The residue was purified by reprecipitation in a solution containing 2-propanol and ethyl acetate at 50:7 (weight ratio) and dried. Thus, an organosilicon compound (resin B, weight average molecular weight 46,000) having a structure of the formula (8) with m being 36 and n (DMS chain number) being 3 was obtained.

(Production of additive B)

A condenser, a mechanical stirrer, a Dean-Stark trap, an oil bath, and a thermometer protecting tube were attached to a 100-mL flask. The flask was charged with 3.9 g of bisaminopropyltetramethyldisiloxane (PAM-E, available from Shin-Etsu Chemical Co., Ltd.), 36.3 g of anisole, 3.53 g of maleic anhydride (available from Tokyo Chemical Industry Co., Ltd.), and they were stirred. The mixture was refluxed in an oil bath at 170°C for two hours. The obtained synthesis solution was cooled to room temperature and then passed through a filter (product number: ADVANTEC T080A075C, available from Toyo Roshi Kaisha, Ltd.). Thus, an additive B having a structure of the following formula (10) was obtained as a precipitate.

[Chem. 7]

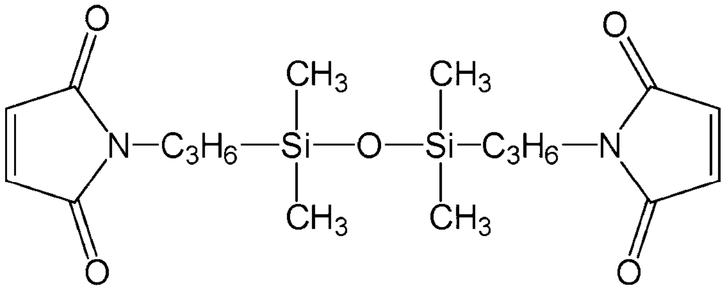

(10)

(Additives C and D)

The following additives were used as additives C and D.

Additive C: TC-401 (available from Matsumoto Fine Chemical Co., Ltd.)
Additive D: BYK-320 (available from BYK-Chemie)

<Evaluation>

The stacks obtained in the examples and the comparative examples were evaluated as follows. Tables 1 and 2 show the results. The stack of Comparative Example 6 was not evaluated because the resin film was largely thermally decomposed, making the CVD impossible.

(Evaluation of cracking in deposition)

In the production of the stack, the formed inorganic layer was visually observed, and cracking in deposition was evaluated in accordance with the following criteria.

◦ (Good): No cracks were found.
× (Poor): Cracks were found.

(Evaluation of heat resistance)

The stack was heat-treated for three hours under a nitrogen atmosphere at 400°C using Rapid Thermal Vacuum

Process Oven (VPO-650, available from UniTemp). Using the heat-treated stack, cracking in the thick film was evaluated in accordance with the following criteria.

◦ (Good): No cracking occurred after heat treatment.
△ (Fair): An end cracked about 2 mm after heat treatment.
× (Poor): A large crack occurred after heat treatment.

(Evaluation of moisture resistance)

The stack was left to stand at a temperature of 85°C and a humidity of 85% for 500 hours. The stack was then visually observed, and the moisture resistance was evaluated in accordance with the following criteria.

◦◦ (Excellent): No mark of water intrusion from an end was found.
◦ (Good): A mark of water intrusion from an end was less than 2 mm.
△ (Fair): A mark of water intrusion from an end was 2 mm or greater and less than 4 mm.
× (Poor): A mark of water intrusion from an end was 4 mm or greater.

[Table 1]

| | | | | | | Example 1 | Example 2 | Example 3 | Example 4 | Example 5 | Example 6 | Example 7 | Example 8 | Example 9 | Example 10 | Example 11 | Example 12 | Example 13 | Example 14 | Example 15 | Example 16 | Example 17 | Example 18 | Example 19 |
|---|---|---|---|---|---|---|---|---|---|---|---|---|---|---|---|---|---|---|---|---|---|---|---|---|
| Structure | Inorganic layer | Outer layer | Deposition condition | | - | 1 | 1 | 2 | 2 | 2 | 3 | 4 | 2 | 4 | 4 | 4 | 4 | 4 | 2 | 5 | 5 | 2 | 4 | 10 |
| | | | Type | | - | SiN | SiN | SiN | SiN | SiN | SiN | SiN | SiN | SiN | SiN | SiN | SiN | SiN | SiN | SiN | SiN | SiN | SiN | SiN |
| | | | Deposition time | | min | 34 | 34 | 31 | 31 | 31 | 34 | 23 | 3 | 12 | 3 | 3 | 3 | 3 | 3 | 25 | 17 | 16 | 23 | 18 |
| | | | Film stress | | Mpa | -184 | -184 | -7 | -7 | -7 | -129 | -53 | -7 | -53 | -53 | -53 | -53 | -53 | -7 | -184 | -184 | -7 | -53 | -201 |
| | | | Thickness | | nm | 400 | 400 | 400 | 400 | 400 | 400 | 400 | 50 | 200 | 50 | 50 | 50 | 50 | 50 | 300 | 200 | 200 | 400 | 200 |
| | | Inner layer | Deposition condition | | - | - | - | - | - | - | - | - | - | - | - | - | - | - | - | 5 | 5 | - | - | - |
| | | | Type | | - | - | - | - | - | - | - | - | - | - | - | - | - | - | - | $SiO_2$ | $SiO_2$ | - | - | - |
| | | | Deposition time | | min | - | - | - | - | - | - | - | - | - | - | - | - | - | - | 1.5 | 1 | - | - | - |
| | | | Film stress | | MPa | - | - | - | - | - | - | - | - | - | - | - | - | - | - | -327 | -327 | - | - | - |
| | | | Thickness | | nm | - | - | - | - | - | - | - | - | - | - | - | - | - | - | 300 | 200 | - | - | - |
| | | P2180/P775 | | | - | 0.040 | 0.040 | 0.043 | 0.043 | 0.043 | 0.026 | 0.033 | 0.018 | 0.023 | 0.023 | 0.023 | 0.023 | 0.023 | 0.019 | 0.030 | 0.029 | 0.035 | 0.034 | 0.079 |
| | | P1200/P775 | | | - | 0.210 | 0.210 | 0.210 | 0.210 | 0.210 | 0.210 | 0.250 | 0.280 | 0.210 | 0.210 | 0.210 | 0.250 | 0.240 | 0.220 | 0.230 | 0.250 | 0.260 | 0.250 | 0.260 |
| | Organic layer | Composition | Main polymer | Type | - | A | A | A | A | A | A | A | A | A | A | A | A | A | A | A | A | B | B | A |
| | | | | Amount | parts by weight | 100 | 100 | 100 | 100 | 100 | 100 | 100 | 100 | 100 | 100 | 100 | 100 | 100 | 100 | 100 | 100 | 100 | 100 | 100 |
| | | | Crosslinking agent | Methyl Silicate 51 | parts by weight | 3.2 | 3.2 | 3.2 | 0 | 0 | 0 | 0 | 0 | 0 | 0 | 3.2 | 3.2 | 0 | 0 | 3.2 | 0 | 3.2 | 0 | 0 |
| | | | | Ethyl Silicate 48 | parts by weight | 0 | 0 | 0 | 0 | 0 | 0 | 0 | 0 | 0 | 0 | 0 | 0 | 0 | 0 | 0 | 15 | 0 | 15 | 15 |
| | | | Catalyst | Zirconia catalyst | parts by weight | 0.2 | 0.2 | 0.2 | 0.1 | 0.1 | 0.1 | 0.1 | 0.1 | 0.1 | 0.1 | 0.2 | 0.2 | 0.1 | 0.1 | 0.1 | 0.05 | 0.1 | 0.05 | 0.05 |
| | | | | Tin catalyst | parts by weight | 0 | 0 | 0 | 0 | 0 | 0 | 0 | 0 | 0 | 0 | 0 | 0 | 0 | 0 | 0 | 0 | 0 | 0 | 0 |
| | | | Additive A | | parts by weight | 1 | 1 | 1 | 3 | 1 | 1 | 1 | 1 | 1 | 1 | 1 | 0 | 0 | 0 | 1 | 1 | 1 | 1 | 1 |
| | | | Additive B | | parts by weight | 0 | 0 | 0 | 0 | 0 | 0 | 0 | 0 | 0 | 0 | 0 | 0 | 0.01 | 0.01 | 0 | 0 | 0 | 0 | 0 |
| | | | Additive C | | parts by weight | 0 | 0 | 0 | 0 | 0 | 0 | 0 | 0 | 0 | 0 | 0 | 0.01 | 0 | 0 | 0 | 0 | 0 | 0 | 0 |
| | | | Additive D | | parts by weight | 0 | 0 | 0 | 0 | 0 | 0 | 0 | 0 | 0 | 0 | 0.1 | 0 | 0 | 0 | 0 | 0 | 0 | 0 | 0 |
| | | Thickness | | | μm | 85 | 30 | 30 | 85 | 30 | 30 | 30 | 30 | 30 | 30 | 30 | 30 | 30 | 30 | 30 | 30 | 30 | 30 | 30 |
| | | 1% Thermal weight loss temperature | | | °C | 475 | 475 | 475 | 449 | 469 | 469 | 469 | 469 | 469 | 469 | 451 | 451 | 447 | 447 | 473 | 452 | 453 | 445 | 452 |
| Evaluation | Cracking in deposition | | | | Rating | ○ | ○ | ○ | ○ | ○ | ○ | ○ | ○ | ○ | ○ | ○ | ○ | ○ | ○ | ○ | ○ | ○ | ○ | ○ |
| | Heat resistance | | | | Rating | ○ | ○ | △ | △ | △ | ○ | ○ | △ | ○ | ○ | ○ | ○ | ○ | △ | ○ | ○ | △ | ○ | ○ |
| | Moisture resistance | | | | Rating | ○○ | ○○ | ○ | ○ | ○ | ○○ | ○○ | ○ | ○○ | ○○ | ○○ | ○○ | ○○ | ○ | ○○ | ○○ | ○ | ○○ | △ |

[Table 2]

| | | | | | | Comparative Example 1 | Comparative Example 2 | Comparative Example 3 | Comparative Example 4 | Comparative Example 5 | Comparative Example 6 |
|---|---|---|---|---|---|---|---|---|---|---|---|
| Structure | Inorganic layer | Outer layer | Deposition condition | | - | 6 | 7 | 8 | 9 | 12 | - |
| | | | Type | | - | SiN | SiN | SiN | SiN | $SiO_2$ | - |
| | | | Deposition time | | min | 31 | 15 | 31 | 29 | 5 | - |
| | | | Film stress | | Mpa | 61 | 152 | 183 | 739 | 277 | - |
| | | | Thickness | | nm | 400 | 200 | 400 | 400 | 200 | - |
| | | Inner layer | Deposition condition | | - | - | - | - | - | - | - |
| | | | Type | | - | - | - | - | - | - | - |
| | | | Deposition time | | min | - | - | - | - | - | - |
| | | | Film stress | | MPa | - | - | - | - | - | - |
| | | | Thickness | | nm | - | - | - | - | - | - |
| | | P2180/P775 | | | - | 0.025 | 0.025 | 0.044 | 0.073 | 0.200 | - |
| | | P1200/P775 | | | - | 0.200 | 0.210 | 0.240 | 0.240 | 0.030 | - |
| | Organic layer | Composition | Main polymer | Type | - | A | A | A | A | A | A |
| | | | | Amount | parts by weight | 100 | 100 | 100 | 100 | 100 | 100 |
| | | | Crosslinking agent | Methyl Silicate 51 | parts by weight | 0 | 0 | 3.2 | 3.2 | 0 | 3.2 |
| | | | | Ethyl Silicate 48 | parts by weight | 0 | 0 | 0 | 0 | 0 | 0 |
| | | | Catalyst | Zirconia catalyst | parts by weight | 0.1 | 0.1 | 0.2 | 0.2 | 0.1 | 0 |
| | | | | Tin catalyst | parts by weight | 0 | 0 | 0 | 0 | 0 | 0.2 |
| | | | Additive A | | parts by weight | 1 | 1 | 1 | 1 | 1 | 1 |

(continued)

| | | | | | Comparative Example 1 | Comparative Example 2 | Comparative Example 3 | Comparative Example 4 | Comparative Example 5 | Comparative Example 6 |
|---|---|---|---|---|---|---|---|---|---|---|
| | | | Additive B | parts by weight | 0 | 0 | 0 | 0 | 0 | 0 |
| | | | Additive C | parts by weight | 0 | 0 | 0 | 0 | 0 | 0 |
| | | | Additive D | parts by weight | 0 | 0 | 0 | 0 | 0 | 0 |
| | | Thickness | | μm | 30 | 30 | 85 | 85 | 30 | 85 |
| | | 1% Thermal weight loss temperature | | °C | 469 | 469 | 475 | 475 | 469 | 370 |
| Evaluation | Cracking in deposition | | | Rating | × | × | × | × | × | - |
| | Heat resistance | | | Rating | × | × | × | × | × | - |
| | Moisture resistance | | | Rating | × | × | × | × | × | - |

[Table 3]

| Deposition condition | Layer | Deposited layer | Deposition device | Chamber internal pressure (Pa) | Temperature | | Gas flow rate | | | | | | | Upper RF Power (Applied voltage) | | Switching mode (RF frequency) | | Deposition rate | Film stress |
|---|---|---|---|---|---|---|---|---|---|---|---|---|---|---|---|---|---|---|---|
| | | | | | Upper | Lower | $SiO_2$ | | | $Si_3N_4$ | | | | | | | | | |
| | | | | | Electrode (°C) | Electrode (°C) | $O_2$ (sccm) | TEOS (sccm) | C-He (sccm) | $SiH_4$ (sccm) | $NH_3$ (sccm) | SN2 (Sccm) | $N_2$ (sccm) | HF (W) | LF (W) | 13.56 MHz (see) | 380 kHz (see) | (nm/min) | (MPa) |
| 1 | Single layer | SiN | MPX-CVD | 130 | 250 | 350 | - | - | - | 5 | 5 | - | 2000 | 30 | 30 | 4<br>End | 44<br>First | 12 | 184<br>Compressive |
| 2 | Single layer | SiN | MPX-CVD | 130 | 250 | 350 | - | - | - | 5 | 5 | - | 2000 | 30 | 30 | 4<br>End | 6<br>First | 12 | 7.2<br>Compressive |
| 3 | Single layer | SiN | MPX-CVD | 130 | 250 | 350 | - | - | - | 5 | 5 | - | 2000 | 30 | 30 | 4<br>End | 28<br>First | 12 | 129<br>Compressive |
| 4 | Single layer | SiN | MPX-CVD | 130 | 250 | 350 | - | - | - | 5 | 5 | - | 2000 | 0 | 50 | - | - | 18 | 53<br>Compressive |
| 5 | Inner layer | $SiO_2$ | MPX-CVD | 140 | 250 | 350 | 750 | 25 | 500 | - | - | - | - | 475 | 100 | - | - | 207 | 327<br>Compressive |
| | Outer layer | SiN | MPX-CVD | 130 | 250 | 350 | - | - | - | 5 | 5 | - | 2000 | 30 | 30 | 4<br>End | 44<br>First | 12 | 184<br>Compressive |
| 6 | Single layer | SiN | MPX-CVD | 130 | 250 | 350 | - | - | - | 5 | 5 | - | 2000 | 30 | 30 | 4<br>End | 8<br>First | 13 | 61<br>Tensile |
| 7 | Single layer | SiN | MPX-CVD | 130 | 250 | 350 | - | - | - | 5 | 5 | - | 2000 | 30 | 30 | 5<br>End | 4<br>First | 13 | 152<br>Tensile |
| 8 | Single layer | SiN | MPX-CVD | 130 | 250 | 350 | - | - | - | 5 | 5 | - | 2000 | 30 | 30 | 8<br>End | 6<br>First | 13 | 183<br>Tensile |
| 9 | Single layer | SiN | MPX-CVD | 130 | 250 | 350 | - | - | - | 5 | 5 | - | 2000 | 30 | 0 | - | - | 14 | 739<br>Tensile |
| 10 | Single layer | SiN | PD-220NL | 160 | 250 | 350 | - | - | - | - | - | 1 | 600 | 270 | 0 | - | - | 12 | 201<br>Compressive |

(continued)

| Deposition condition | Layer | Deposited layer | Deposition device | Chamber internal pressure (Pa) | Temperature | | Gas flow rate | | | | | | | Upper RF Power (Applied voltage) | | Switching mode (RF frequency) | | Deposition rate | Film stress |
|---|---|---|---|---|---|---|---|---|---|---|---|---|---|---|---|---|---|---|---|
| | | | | | Upper | Lower | $SiO_2$ | | | $Si_3N_4$ | | | | | | | | | |
| | | | | | Electrode (°C) | Electrode (°C) | $O_2$ | TEOS | C-He | $SiH_4$ | $NH_3$ | SN2 | $N_2$ | HF | LF | 13.56 MHz | 380 kHz | (nm/min) | (MPa) |
| | | | | | | | (sccm) | (sccm) | (sccm) | (sccm) | (sccm) | (Sccm) | (sccm) | (W) | (W) | (see) | (see) | | |
| 11 | Single layer | $SiO_2$ | PD-220NL | 65 | 250 | 350 | 195 | 5 | - | - | - | - | - | 250 | 0 | - | - | 19 | 300<br>Compressive |
| 12 | Single layer | $SiO_2$ | PD-220NL | 80 | 250 | 350 | 195 | 5 | - | - | - | - | - | 30 | 0 | - | - | 38 | 277<br>Tensile |

INDUSTRIAL APPLICABILITY

The present invention can provide a stack that, when a plurality of the stacks are stacked, can provide a semiconductor device in which elements are less likely to warp or crack, that has high moisture resistance, and that can impart excellent connection reliability, a method for producing the stack, a method for producing an element using the stack, an imaging device including the stack, a method for producing the imaging device, a semiconductor device including the stack, and a method for producing the semiconductor device.

REFERENCE SIGNS LIST

1 first element
2 organic layer
3 inorganic layer
4 chip
5 supporting substrate
6 substrate including electrode
7 electrode
8 through-hole
9 barrier metal layer
10 substrate including electrode

**Claims**

**1.** A stack comprising:

a first element;
an organic layer on the first element; and
an inorganic layer on the organic layer,
the organic layer having a 1% thermal weight loss temperature of 400°C or higher as measured at a temperature increase rate of 10°C/min under a nitrogen atmosphere,
the inorganic layer having a thickness of 1 nm or greater and 1 μm or less,
the inorganic layer including a $Si_3N_4$ layer,
the inorganic layer having a compressive internal stress.

**2.** The stack according to claim 1,
wherein the inorganic layer includes a $SiO_2$ layer, and the $Si_3N_4$ layer is on the $SiO_2$ layer.

**3.** The stack according to claim 1 or 2,
wherein the organic layer is a cured product of a curable resin composition.

**4.** The stack according to claim 3,
wherein the organic layer is a cured product of a curable resin composition containing an organosilicon compound.

**5.** The stack according to claim 4,
wherein the organosilicon compound has a structure represented by the following formula (1):

[Chem. 1]

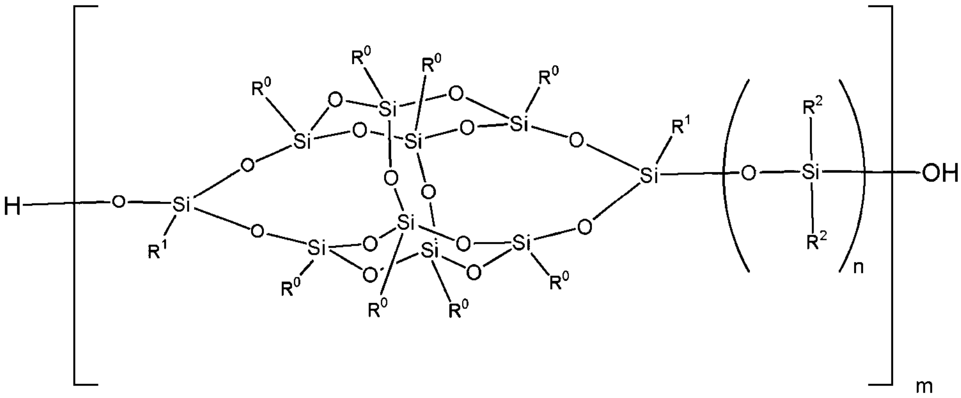

(1)

wherein $R^0$s, $R^1$s, and $R^2$s each independently represent a linear, branched, or cyclic aliphatic group, an aromatic group, or hydrogen; the aliphatic group and the aromatic group optionally have a substituent; and m and n each represent an integer of 1 or greater.

6. The stack according to claim 5,
wherein the stack satisfies P2180/P775 < 0.045, where P775 is a peak height at 775 $cm^{-1}$ (Si-O) and P2180 is a peak height at 2,180 $cm^{-1}$ (Si-H) in an IR spectrum measured from a surface of the inorganic layer by FT-IR.

7. The stack according to claim 5 or 6,
wherein the stack satisfies P1200/P775 < 0.300, where P775 is a peak height at 775 $cm^{-1}$ (Si-O) and P1200 is a peak height at 1,200 $cm^{-1}$ (N-H) in an IR spectrum measured from a surface of the inorganic layer by FT-IR.

8. The stack according to any one of claims 1 to 7,
wherein the organic layer has a thickness of 10 μm or greater.

9. The stack according to any one of claims 1 to 8,
wherein the first element has a first surface and a second surface, the first surface includes a plurality of chips, and the organic layer and the inorganic layer are on the first surface side.

10. The stack according to any one of claims 1 to 9, further comprising a supporting substrate on the inorganic layer.

11. An imaging device comprising the stack according to any one of claims 1 to 10.

12. A semiconductor device comprising the stack according to any one of claims 1 to 10.

13. A method for producing the stack according to any one of claims 1 to 10, comprising the steps of:

forming the organic layer by forming a film of a curable resin composition on the first element; and
forming the inorganic layer having a compressive internal stress on the organic layer by chemical vapor deposition.

14. The method for producing the stack according to claim 13,
wherein the first element has a first surface and a second surface, the first surface includes a plurality of chips, and the organic layer is formed on the first surface side in the organic layer forming step.

15. The method for producing the stack according to claim 13 or 14, further comprising the step of bonding a supporting substrate onto the inorganic layer.

16. A method for producing an imaging device, comprising the step of producing an imaging device using a stack obtained by the production method according to any one of claims 13 to 15.

17. A method for producing an element, comprising the steps of:

forming an organic layer by forming a film of a curable resin composition on a surface of a substrate including an

electrode, the surface being a surface including the electrode;
forming an inorganic layer having a compressive internal stress on the organic layer by chemical vapor deposition;
forming a through-hole in the organic layer and the inorganic layer;
filling the through-hole with a conductive material; and
forming a bonding electrode by polishing the surface of the substrate on the side where the through-hole is filled with the conductive material.

**18.** A method for producing an imaging device, comprising the step of producing an imaging device using an element obtained by the method for producing an element according to claim 17.

**19.** A method for producing a semiconductor device, comprising the step of bonding two elements, each obtained by the method for producing an element according to claim 17, such that the bonding electrodes are bonded to each other.

FIG.1

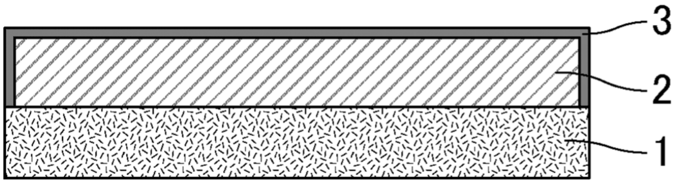


FIG.2

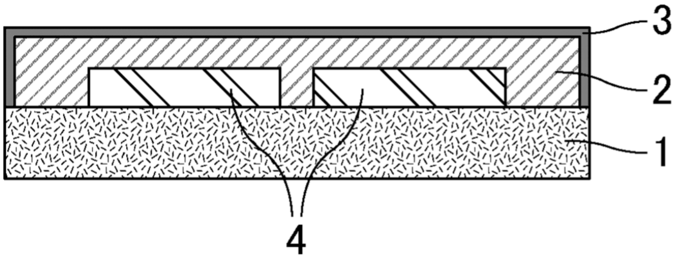


FIG.3

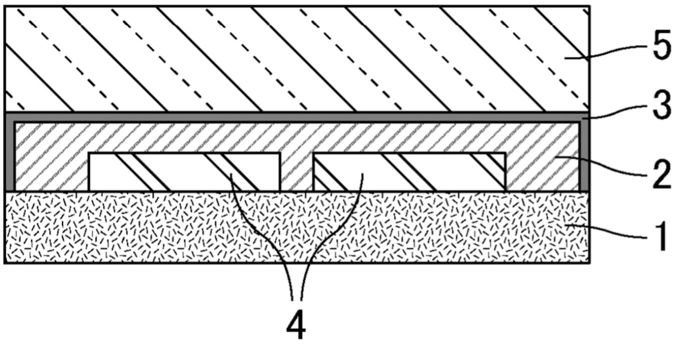


FIG.4

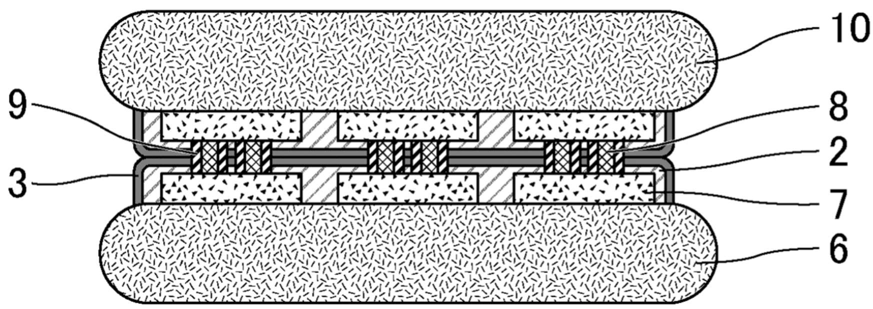

## INTERNATIONAL SEARCH REPORT

International application No.
**PCT/JP2024/001591**

### A. CLASSIFICATION OF SUBJECT MATTER

***B32B 9/00***(2006.01)i; ***H01L 21/312***(2006.01)i; ***H01L 21/316***(2006.01)i; ***H01L 21/318***(2006.01)i
FI: B32B9/00 A; H01L21/312 B; H01L21/312 C; H01L21/316 X; H01L21/318 B

According to International Patent Classification (IPC) or to both national classification and IPC

### B. FIELDS SEARCHED

Minimum documentation searched (classification system followed by classification symbols)

B32B9/00; H01L21/312; H01L21/316; H01L21/318

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2009-152485 A (SEIKO EPSON CORPORATION) 09 July 2009 (2009-07-09) claims, fig. 1-20 | 1-19 |
| A | JP 11-271123 A (DENSO CORPORATION) 05 October 1999 (1999-10-05) claims, fig. 1-7 | 1-19 |
| A | JP 6-260397 A (TOPPAN PRINTING CO., LTD.) 16 September 1994 (1994-09-16) claims, fig. 1-7 | 1-19 |
| A | JP 2007-125626 A (KABUSHIKI KAISHA TOSHIBA) 24 May 2007 (2007-05-24) claims, fig. 1-26 | 1-19 |
| A | JP 7144624 B2 (SEKISUI CHEMICAL CO., LTD.) 29 September 2022 (2022-09-29) claims, examples, fig. 1, 2 | 1-19 |
| A | JP 2019-196936 A (HITACHI AUTOMOTIVE SYSTEMS, LTD.) 14 November 2019 (2019-11-14) claims, fig. 1-8 | 1-19 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 March 2024** | **26 March 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No. **PCT/JP2024/001591**

**C. DOCUMENTS CONSIDERED TO BE RELEVANT**

| Category* | Citation of document, with indication, where appropriate, of the relevant passages | Relevant to claim No. |
|---|---|---|
| A | JP 2005-149751 A (OLYMPUS CORPORATION) 09 June 2005 (2005-06-09) claims, fig. 1-8 | 1-19 |
| A | JP 2022-504537 A (FRAUNHOFER-GESELLSCHAFT ZUR FORDERUNG DER ANGEWANDTEN FORSCHUNG E. V.) 13 January 2022 (2022-01-13) claims, fig. 1-9 | 1-19 |
| A | WO 2009/041528 A1 (CITIZEN HOLDINGS CO., LTD.) 02 April 2009 (2009-04-02) claims, fig. 1-9 | 1-19 |

Form PCT/ISA/210 (second sheet) (July 2022)

**INTERNATIONAL SEARCH REPORT**
**Information on patent family members**

International application No.
**PCT/JP2024/001591**

| Patent document cited in search report | Publication date (day/month/year) | Patent family member(s) | Publication date (day/month/year) |
|---|---|---|---|
| JP 2009-152485 A | 09 July 2009 | (Family: none) | |
| JP 11-271123 A | 05 October 1999 | US 6450025 B1<br>claims, fig. 1-6 | |
| JP 6-260397 A | 16 September 1994 | (Family: none) | |
| JP 2007-125626 A | 24 May 2007 | (Family: none) | |
| JP 7144624 B2 | 29 September 2022 | US 2023/0245936 A1<br>claims, examples, fig. 1, 2<br>WO 2021/261403 A1<br>EP 4169971 A1<br>CN 115244670 A<br>KR 10-2023-0028205 A | |
| JP 2019-196936 A | 14 November 2019 | WO 2019/215981 A1 | |
| JP 2005-149751 A | 09 June 2005 | US 2005/0109768 A1<br>claims, fig. 1-8<br>EP 1531651 A2 | |
| JP 2022-504537 A | 13 January 2022 | US 2021/0257502 A1<br>EP 3864713 A2 | |
| WO 2009/041528 A1 | 02 April 2009 | US 2010/0196685 A1<br>claims, fig. 1-9<br>EP 2196870 A1<br>CN 101809512 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006191081 A